# EUROPEAN PATENT APPLICATION

(11) **EP 2 244 490 A1**
(43) Date of publication of application: **27.10.2010**
(21) Application number: 09100240.2
(22) Date of filing: 20.04.2009
(51) Int. Cl.: H04R 19/00, H04R 19/04, H04R 31/00, H04R 7/18

(54) **Silicon condenser microphone with corrugated backplate and membrane**

(71) Applicant: NXP B.V., 5656 AG Eindhoven (NL)
(72) Inventor: Langereis, Geert, Redhill, Surrey RH1 1DL (GB); Lippen, Twan van, Redhill, Surrey RH1 1DL (GB); Roozeboom, Freddy, Redhill, Surrey RH1 1DL (GB); Suy, Hilco, Redhill, Surrey RH1 1DL (GB); Reimann, Klauss, Redhill, Surrey RH1 1DL (GB); Van Beek, Jozef, Redhill, Surrey RH1 1DL (GB); Avoort, Cas van der, Redhill, Surrey Rh1 1DL (GB); Wingerden, Johannes, Redhill, Surrey RH1 1DL (GB); Le Phan, Kim, Redhill, Surrey RH1 1DL (GB); Goosens, Martin, Redhill, Surrey RH1 1DL (GB); Steeneken, Peter, Redhill, Surrey RH1 1DL (GB)
(74) Representative: Williamson, Paul Lewis

(57) **Abstract**

A microphone comprises a substrate (20), a microphone membrane (10) defining an acoustic input surface and a backplate (11) supported with respect to the membrane with a fixed spacing between the backplate (11) and the membrane (10). A microphone periphery area comprises parallel corrugations (24) in the membrane (10) and backplate (11).

By using the same corrugated suspension for both the membrane and the backplate, the sensitivity to body noise is optimally suppressed.

## Description

This invention relates to a microphone, particularly a silicon capacitive condenser microphone.

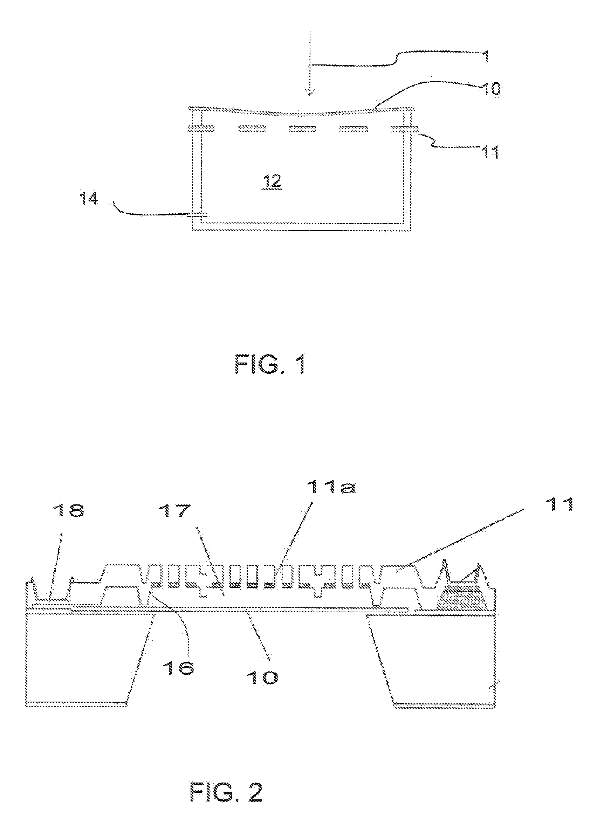

Figure 1 shows schematically the principle of operation of a known capacitive condenser microphone. Sound pressure waves 1 make a membrane 10 vibrate due to a pressure difference over the membrane. This varies the airgap spacing between the membrane 10 and a backplate 11. For a good omni-directional performance, the back side of the membrane faces an acoustically closed back chamber 12. A small hole 14 in the back chamber is required to compensate for slow changes in atmospheric pressure.

In order to detect the movement of the membrane, it is placed in a parallel plate capacitor set-up. To do so, the membrane has a conducting surface and the back-plate is also conducting, placed to create the air gap. An electrically detectable signal, proportional to the sound pressure, is available due to modulation of the air gap by the sound pressure difference.

The membrane and backplate are normally made in a silicon MEMS process while the back-chamber can be defined by the device package.

MEMS microphones are of particular interest for applications requiring miniaturization, for example for mobile phones and for PCB mounting in other hand held devices.

The sensitivity of the microphone is determined by the compliance (i.e. flexibility) of the acoustical membrane. This can easily be understood because a large membrane displacement is desired for a low acoustical pressure level in order to detect the membrane displacement easily. The compliance is controlled by both the mechanical construction and the material parameters (stress and Young's modulus). However, depending on the design, one of these parameters dominates the performance.

In many MEMS microphones, the membrane is attached at its complete perimeter. Such a membrane is therefore stretched as a drum and the mechanical properties (and thus the sensitivity of the microphone) are strongly dependent on the tensile stress in the membrane.

In that case, the membrane must have a tensile stress as low as possible in order to give it a high compliance (flexibility). However, even the smallest compressive stress is unacceptable because that will buckle the membrane and completely distort the performance. It is therefore the art of the process controller to make membranes with a low (SMPa to 50MPa) tensile stress. In other words, the microphone performance is defined by the fabrication process.

Popular membrane materials in the 1990's were PECVD Silicon Nitrides because these could be made reproducible using low temperature processes resulting in the desired tensile stress range. Later on, polysilicon was used for the membrane for an improved thermal matching with the substrate. However, the reproducibility of tuning of the low stress is problematic.

To make silicon MEMS microphones with a performance which is not primarily controlled by the process parameters, some options for improved designs are used.

For example, when the membrane is suspended by beams the compliance is determined by the spring constant of the beams. This is easier to control than a stress level in a layer. However, a consequence of beams from a fixed substrate to the membrane is that an acoustical path is created from the front to the back of the membrane. This influences the sensitivity and directivity of the microphone.

Another known approach (used by Knowles Acoustics) uses a "Free Floating Diaphragm". Figure 2 shows this approach.

The poly-silicon microphone diaphragm 10 is not rigidly attached to the supporting structure. The diaphragm 10 is supported, but not physically attached, by posts 16 that follow a circular pattern around the edge of the diaphragm. Thus, the diaphragm is said to be 'free-floating' within the MEMS structure. In the electrostatically charged state, these diaphragm support posts establish the separation (airgap 17) between the diaphragm and the back-plate 11, of around 4 microns. There is a single physical connection that provides an electrical conduit from the diaphragm to the bond pad 18. Figure 2 shows the backplate with a conductive coating 11 a forming the backplate electrode.

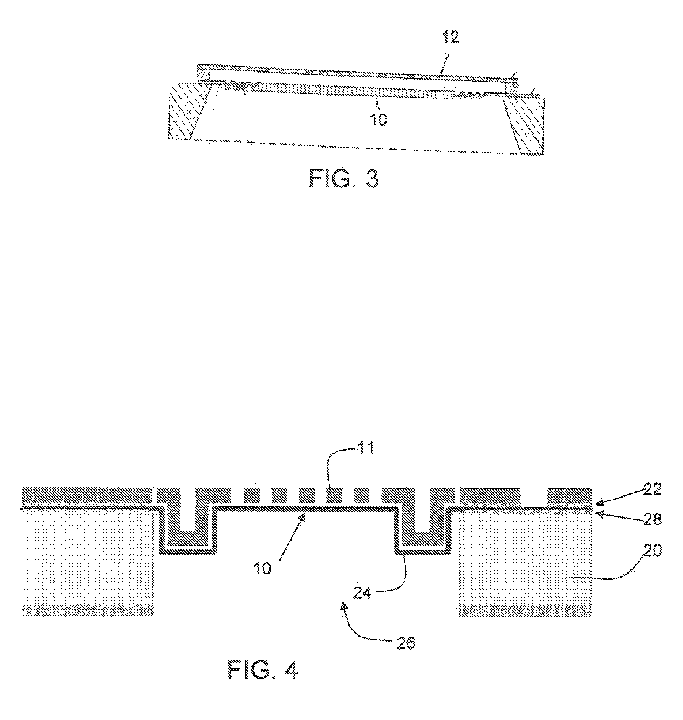

Besides free-hanging and beams, there is an intermediate solution which is a membrane with corrugations at the rim. This gives the membrane is increased flexibility at the rim, as shown in Figure 3.

One problem not addressed by these designs is body noise suppression.

Body noise is the disturbing effect of mechanical vibrations resulting in an electrical output from the microphone. For example, when a mobile phone is scratched over the cheek, the resulting mechanical vibrations are experienced by the receiver as sound. Another example is the crosstalk of a mobile phone's own speaker into the microphone. Both effects cannot be compensated adequately by signal processing. They have to be minimised by a microphone design which is less sensitive to mechanical vibrations.

According to the invention, there is provided a method manufacturing a microphone, comprising:
forming a channel arrangement in a substrate, the channel arrangement positioned around the periphery of a microphone area;
forming a microphone membrane layer defining an acoustic input surface, a sacrificial layer and a backplate layer over the substrate surface;
etching the backplate layer to define openings; and
removing the sacrificial layer by etching through the backplate openings; and
removing a portion of the substrate beneath the input surface,
thereby forming a microphone structure having a microphone periphery area with parallel corrugations in the membrane and backplate layer.

In a capacitive MEMS microphone, it is desirable to optimise the sensitivity of the membrane to acoustic pressure and minimise the sensitivity to mechanical vibrations. This can be done intrinsically by giving the membrane a high compliance and by matching the frequency responses of membrane and backplate. In conventional designs, this is realised by either optimising process parameters or by suspending the membrane from beams. The method of the invention provides corrugation of the rim of the membrane and the rim of the backplate in a single process step.

An advantage of corrugated membranes over drum-type membranes is that the deflection profile can be controlled to increase the sensitivity. The shape will have more sharp edges similar to a square wave profile instead of the smooth edges of a sine wave profile. This can achieve an increase in sensitivity of a factor of two. By using the same corrugated suspension for both the membrane and the backplate, the sensitivity to body noise is optimally suppressed, in particular by avoiding two different deflection profiles. Thus, mechanical vibrations result in equal excursions of the membrane and backplate. This means there is no electrical output due to mechanical noise. Sound results in motion of the membrane only and can still be measured. In other words, mechanical body noise is a common driver for the membrane and backplate while sound is a differential input.

An insulator layer is preferably formed beneath the microphone membrane layer. This insulates the substrate from the membrane. This insulator layer can also be used as an etch stop when removing the portion of the substrate. The substrate preferably comprises a silicon wafer.

The channels can comprise reactive ion etched trenches. The single processing step of forming the channels subsequently results in the parallel corrugations in the backplate and the membrane. In one example, the channels are formed by a sequence of isotropic etching and passivation steps to form rippled channel side walls. These rippled side walls can be used to design the mechanical suspension properties of the membrane.

The membrane preferably comprises polysilicon, and the sacrificial layer can comprise TEOS. The backplate layer can comprise polysilicon.

The invention also provides a microphone, comprising:
a substrate;
a microphone membrane defining an acoustic input surface;
a backplate supported with respect to the membrane with a fixed spacing between the backplate and the membrane, the backplate having openings;
wherein the substrate has an opening beneath the input surface,
and wherein a microphone periphery area comprises parallel corrugations in the membrane and backplate with the fixed spacing.

By providing parallel corrugations, the body noise suppression is improved, as the membrane and backplate respond in the same way to body noise.

The resonance frequency of the backplate can be designed to match the resonance frequency of the membrane, in order to compensate intrinsically for body noise.

The periphery area can have a quadrilateral shape. The use of corrugations means the inner area (particularly near the corners) is more effectively used as an input surface.

Examples of the invention will now be described in detail with reference to the accompanying drawings, in which:
Figure 1 shows schematically the principle of operation of a capacitive MEMS microphone;
Figure 2 shows a first example of known MEMS microphone design;
Figure 3 shows a second example of known MEMS microphone design;
Figure 4 shows an example of MEMS microphone design of the invention;
Figure 5 shows an example of process sequence in accordance with the invention;
Figure 6 shows the deflection profile of perimeter-clamped conventional square microphone membranes;
Figures 7 and 8 show how the microphone design of the invention addresses the problem explained with reference to Figure 6; and
Figure 9 shows how the formation of corrugations can be modified.

The drawings are not to scale, and some dimensions may have been exaggerated (for example the thickness dimension) to make the drawings show the different components more clearly.

The invention provides a microphone design with one or more corrugations (i.e. channels or peaks which depart from and return to a planar profile) in the backplate and the membrane (i.e. the two microphone electrodes). This provides various advantages, including body noise suppression.

Figure 4 shows an example of microphone of the invention having a single corrugation. Figure 4 shows the membrane 10, perforated backplate 11 and substrate 20. The membrane and backplate are provided with a fixed spacing at the support rim, with an insulator layer 22 between the two layers.

The rim of both the membrane and the backplate in the capacitive MEMS microphone are corrugated. These corrugations 24 are parallel between the membrane and backplate with the fixed spacing.

Figure 4 shows a single corrugation, namely a single "U" shaped channel 24 around the periphery of the acoustic input surface defined by the membrane. More concentric corrugations are optional.

The substrate 20 has an opening 26 beneath the input surface,

A further insulator layer 28 is provided beneath the microphone membrane layer and the backplate which is present outside the microphone membrane periphery area.

The parallel corrugations are formed by a single process step in the form of a trench-etch prior to defining the membrane/backplate/sacrificial layer stack.

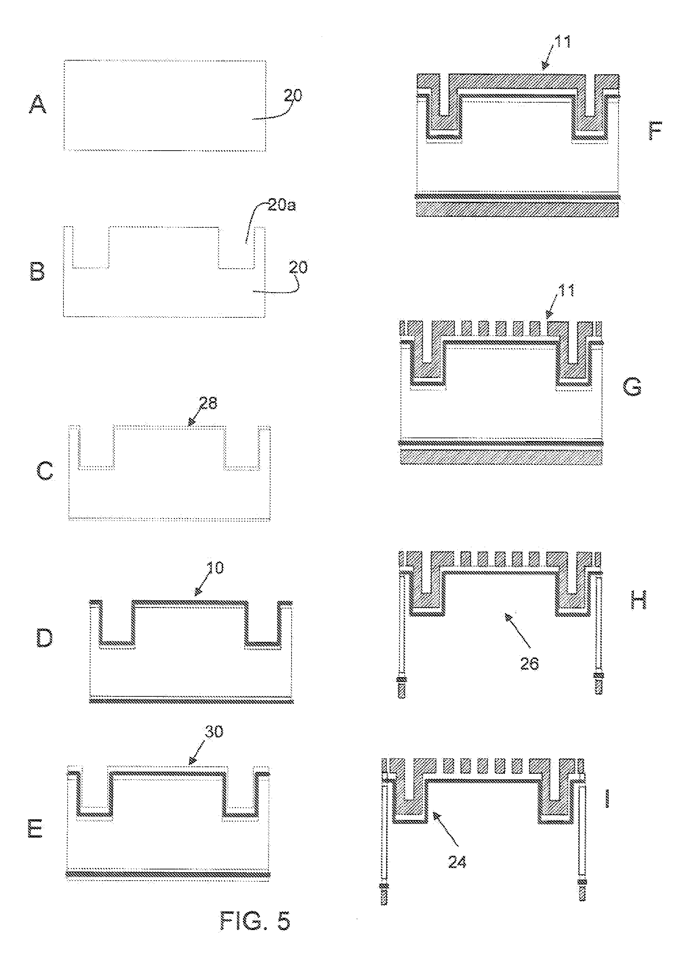

Figure 5 shows the process steps for a membrane and a back plate with corrugations in a single process. It is a simplified explanation of the process, in that contact holes for electrical connection to the membrane and to the backplate are not shown - these will be included routinely by those skilled in the art. Similarly, contact holes to the substrate are omitted. These are needed to define the potential of the substrate in order to minimise the parasitic capacitance between the membrane and the substrate.

Figure 5A shows a double polished, thinned silicon wafer 20.

Figure 5B shows that circular trenches 20a are etched at the rim of the future microphone. Only one circle is shown, but the design can include multiple concentric trenches. The trench may have a depth of 50µm (or in the range 10 to 200 µm) and a smaller width, for example 25 µm (or in the range 5 to 200 µm). The trenches thus have a depth such that the resulting microphone membrane (which is conformal with the trench) will deform preferentially at the trench location. For example, the trench depth is preferably at least double the thickness of the thicker of the membrane and backplate. More preferably, the trench depth is at least 5 times the thickness of the thicker of the membrane and the backplate, so that the resulting profile of the membrane and the backplate will bend at that location in response to a mechanical vibration source.

Figure 5C shows a uniform silicon oxide layer 28 applied to electrically insulate the membrane from the substrate. It is also used as an etch stop for back-side etching later. This may for example be 1 µm thick.

Figure 5D shows the membrane 10 applied. This is a low stress poly silicon of a typical thickness of 0.3 µm. A low thickness will reduce the membrane mass resulting to a higher resonance frequency of the microphone.

Polysilicon is chosen because it has the best match in temperature dependency compared to the silicon substrate. For optimum mechanical decoupling by corrugation, also the thermal matching becomes less critical.

Figure 5E shows a sacrificial layer 30 applied by growing TEOS, typically between 2 µm and 3 µm.

Figure 5F shows the backplate 11 applied. Figure 5G shows the patterning of the backplate to form the desired openings. One example is low stress polysilicon. It can be as thin as the membrane, but slightly thicker will give some additional robustness and allows correction for softening which may arise during the air-hole etching. Mechanical simulation or calculations are used for optimum body noise cancellation. Typical thickness ranges are 0.5 µm to 5 µm.

Figure 5H shows that the substrate is partially etched to give access to the membrane/backplate stack by means of the channel 26. This example uses so-called "front opening" because the bottom (substrate) side will become the acoustical entrance when used as a microphone. The preferred process is Deep Reactive Ion Etching (DRIE) to make cylinder-shaped front openings. Alternatively, anisotropic etching using KOH or TMAH can be used to make a pyramid shaped front-opening.

Finally, a sacrificial layer etch releases the membrane and removes the oxide under the membrane.

This process defines the corrugations in the membrane and backplate by a single deep-etch step.

The use of corrugations gives additional advantages in terms of the possible microphone bending profile.

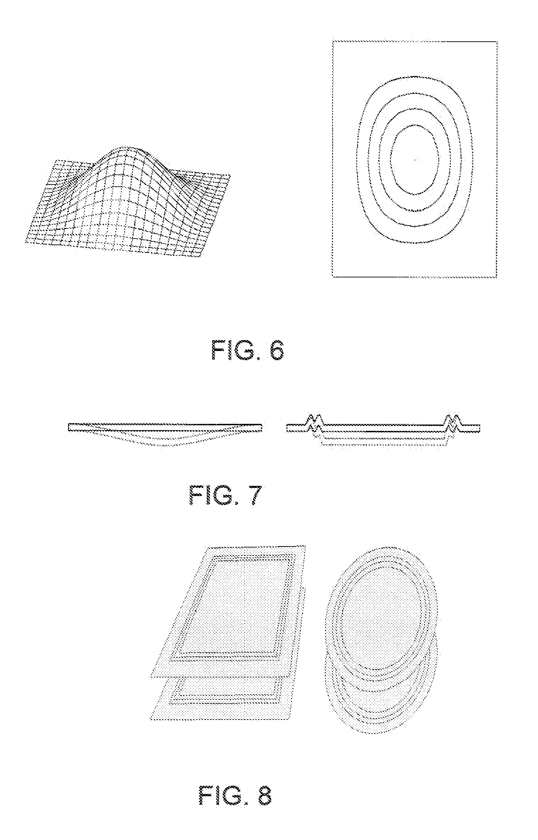

A square flat membrane which is connected to the substrate on four edges (referred to as "drum-type") has a deflection profile as shown in Figure 6 when under uniform pressure. The deflection is concentrated in the centre of the membrane, whereas at the edges there is hardly any displacement, especially outside the circular deflection profile. In this case, not much signal would be lost by using a round membrane of the same edge length because there is no deflection in the corners. Therefore, microphones with this type of membrane normally use circular configurations. This is a waste of area and hence potential sensitivity because silicon chips are square.

Figure 7 shows that when membranes which are corrugated at the rim are used, there is a much more efficient displacement of the membrane. This can yield up to 50% of additional signal strength for the same maximum displacement.

Figure 7 shows deflection profiles in side view for non-corrugated (left image) and corrugated (right image) membranes.

Unlike the drum-type membrane, now there is an advantage of using square membranes as shown in Figure 8. The displacement is present in the corners as well. This can yield up to 4/π - 1 = 27% larger effective area.

Thus, for corrugated membranes, significantly more sensitivity can be achieved on the same silicon chip when using a square membrane.

The corrugations have been shown so far as "U" shaped channels with planar side walls. However, the trench side walls can be rippled, and this will influence the deformation characteristics.

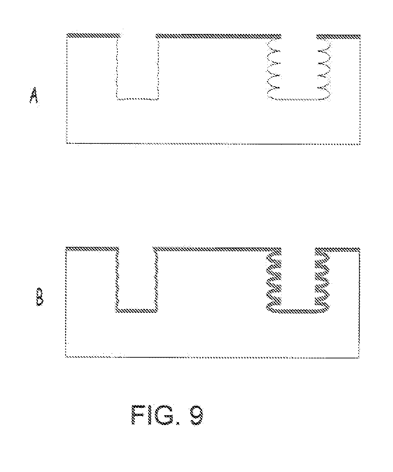

The most common process to make trenches in silicon is the so-called "Bosch process". A side view is shown in Figure 9.

Figure 9A shows a first stage, in which a mask is used to define the trenches. Through this mask, a subsequent sequence of isotropic etching and passivation is used to etch straight into the silicon substrate. This cycled processing inevitably results in the gently rippled walls as shown on the left.

Figure 9B shows the structure after the mask is removed, and a uniform silicon oxide layer is applied.

On the right hand side of Figures 9A and 9B, the ratio between etching and passivation is chosen such that the ripples become very deep. The deep ripples give a substrate for double-corrugated trenches with an increase in mechanical compliance. These can be considered to be secondary corrugations.

The invention can enable a lower residual lateral stress in the membrane, and hence higher sensitivity. The body noise suppression is greatly improved. The process can give simple manufacturability due to self-alignment.

The term "corrugation" should be understood to include a single channel or projection from an otherwise planar profile. Of course, multiple such channels or projections can be provided.

The example above has the substrate channel opening to the membrane. However, the same advantages of the invention can be obtained in a design with the backplate facing the substrate. There are known MEMS designs with this configuration. Thus, the steps of forming a microphone membrane layer, a sacrificial layer and a backplate layer over the substrate are not necessarily in that order. Similarly, the substrate opening "beneath the input surface" of the microphone can be on the membrane side or the backplate side.

Various modifications will be apparent to those skilled in the art.

## Claims

1. A method manufacturing a microphone, comprising:
forming a channel arrangement (20a) in a substrate (20), the channel arrangement positioned around the periphery of a microphone area;
forming a microphone membrane layer (10) defining an acoustic input surface, a sacrificial layer (30) and a backplate layer (11) over the substrate surface;
etching the backplate layer (11) to define openings; and
removing the sacrificial layer (30) by etching through the backplate openings and
removing a portion (26) of the substrate (20) beneath the input surface,
thereby forming a microphone structure having a microphone periphery area with parallel corrugations (24) in the membrane (10) and backplate layer (11).

2. A method as claimed in claim 1, wherein an insulator layer (28) is formed beneath the microphone membrane layer.

3. A method as claimed in claim 2, wherein the insulator layer (28) is used as an etch stop when removing the portion (26) of the substrate.

4. A method as claimed in claim any preceding claim, wherein the substrate (20) comprises a silicon wafer.

5. A method as claimed in claim 4, where the portion of the silicon substrate is removed using Deep Reactive Ion Etching to form the channel arrangement (20a).

6. A method as claimed in claim 4, wherein the channel arrangement (20a) is formed by a sequence of isotropic etching and passivation steps to form rippled channel side walls.

7. A method as claimed in claim any preceding claim, wherein the membrane layer (10) comprises polysilicon.

8. A method as claimed in claim any preceding claim, wherein the sacrificial layer (30) comprises TEOS.

9. A method as claimed in claim any preceding claim, wherein the backplate layer (11) comprises polysilicon.

10. A microphone, comprising:
a substrate (20);
a microphone membrane (10) defining an acoustic input surface;
a backplate (11) supported with respect to the membrane with a fixed spacing between the backplate (11) and the membrane (10), the backplate having openings;
wherein the substrate has an opening (26) beneath the input surface,
and wherein a microphone periphery area comprises parallel corrugations (24) in the membrane (10) and backplate (11) with the fixed spacing.

11. A microphone as claimed in claim 10, where the resonance frequency of the backplate matches the resonance frequency of the membrane.

12. A microphone as claimed in claim 10 or 11, wherein the periphery area has a quadrilateral shape.

13. A microphone as claimed in claim 10, 11 or 12, wherein the membrane (10) is provided over the substrate, and the backplate (11) is provided over the membrane, the microphone further comprising an insulator layer beneath the membrane (10) and the backplate (11) which is present outside the microphone periphery area.

14. A microphone as claimed in any one of claims 10 to 13, wherein the substrate (20) comprises a silicon wafer, the membrane comprises polysilicon and the backplate comprises polysilicon.

15. A microphone as claimed in any one of claims 10 to 14, wherein the side walls of the corrugations have rippled surfaces.
